# EUROPEAN PATENT APPLICATION

(11) **EP 4 557 381 A1**
(43) Date of publication of application: **21.05.2025**
(21) Application number: 23851399.8
(22) Date of filing: 26.06.2023
(51) Int. Cl.: H01L 31/0232

(54) **GROUP III-V SEMICONDUCTOR PHOTOELECTRIC DETECTOR AND OPTICAL RECEIVING MODULE**

(30) Priority: 11.08.2022 CN 202210966801
(71) Applicant: Huawei Technologies Co., Ltd., Shenzhen, Guangdong 518129 (CN)
(72) Inventor: QIU, Xinjia, Shenzhen, Guangdong 518129 (CN); CAO, Rixiang, Shenzhen, Guangdong 518129 (CN); REN, Zhengliang, Shenzhen, Guangdong 518129 (CN)
(74) Representative: Maiwald GmbH
(86) International application number: PCT/CN2023/102510
(87) International publication number: WO 2024/032172

(57) **Abstract**

This application provides a III-V semiconductor photodetector, used in the field of semiconductor devices. The photodetector includes an upper electrode layer, an absorption layer, and a lower electrode layer in sequence in a first direction. The upper electrode layer and the lower electrode layer are used to provide a bias voltage for the absorption layer. The absorption layer is used to: receive an optical signal, and convert the optical signal into an electrical signal based on the bias voltage. A dielectric metasurface is disposed on the upper electrode layer. The dielectric metasurface is used to enable the optical signal to resonate in the absorption layer. The photodetector further includes a dielectric layer. The absorption layer is located between the dielectric layer and the upper electrode layer. There is an overlapping region between a projection of the dielectric layer on the upper electrode layer and the dielectric metasurface. A refractive index of the dielectric layer is less than a refractive index of the absorption layer. In this application, the dielectric layer with a low refractive index is introduced, so that an optical field localization effect can be improved, thereby improving efficiency corresponding to the dielectric metasurface. Therefore, in this application, quantum efficiency of the photodetector can be improved.

## Description

This application claims priority to Chinese Patent Application No. 202210966801.8, filed with the China National Intellectual Property Administration on August 11, 2022 and entitled "III-V SEMICONDUCTOR PHOTODETECTOR AND OPTICAL RECEIVER MODULE", which is incorporated herein by reference in its entirety.

### TECHNICAL FIELD

This application relates to the field of semiconductor devices, and in particular, to a III-V semiconductor photodetector and an optical receiver module.

### BACKGROUND

A semiconductor photodetector is an important device in the field of optical communication, and is configured to convert an optical signal into an electrical signal. A response speed and quantum efficiency of the photodetector are mutually restricted. Specifically, usually, thickening an absorption layer of the photodetector can increase the quantum efficiency, but reduce the response speed (also referred to as bandwidth) of the photodetector. By contrast, thinning the absorption layer can improve the response speed, but reduce the quantum efficiency of the photodetector. Materials of the semiconductor photodetector mainly include III-V and silicon-germanium Si-Ge systems. In the Si-Ge system, a dielectric metasurface may be disposed on an active layer. The dielectric metasurface is used to enable the optical signal to resonate in the absorption layer, to improve the quantum efficiency of the photodetector. After the quantum efficiency of the photodetector is improved, the absorption layer can be thinned, to improve the response speed of the photodetector. Therefore, the mutual restriction between the response speed and the quantum efficiency can be resolved via the dielectric metasurface.

In practice, however, the dielectric metasurface is not well applied in the III-V system, to effectively improve the quantum efficiency of the photodetector as expected.

### SUMMARY

This application provides a III-V semiconductor photodetector, an optical receiver module, and an optical communication device. A dielectric layer with a low refractive index is introduced, so that an optical field localization effect can be improved, thereby improving efficiency corresponding to a dielectric metasurface. Therefore, in this application, quantum efficiency of the photodetector can be improved.

A first aspect of this application provides a III-V semiconductor photodetector, which is referred to as a photodetector for short. The photodetector includes an upper electrode layer, an absorption layer, and a lower electrode layer in sequence in a first direction. The upper electrode layer and the lower electrode layer are used to provide a bias voltage for the absorption layer. The absorption layer is used to: receive an optical signal, and convert the optical signal into an electrical signal based on the bias voltage. A dielectric metasurface is disposed on the upper electrode layer. The dielectric metasurface is used to enable the optical signal to resonate in the absorption layer. The photodetector further includes a dielectric layer. The absorption layer is located between the dielectric layer and the upper electrode layer. There is an overlapping region between a projection of the dielectric layer on the upper electrode layer and the dielectric metasurface. A refractive index of the dielectric layer is less than a refractive index of the absorption layer.

In an optional manner of the first aspect, the refractive index of the dielectric layer ranges from 1 to 1.5. A larger difference between the refractive index of the dielectric layer and the refractive index of the absorption layer indicates a more obvious improvement of an optical field localization effect. The optical field localization effect can be effectively improved by limiting the refractive index of the dielectric layer.

In an optional manner of the first aspect, a material of the dielectric layer is air, silicon dioxide, or a benzocyclobutene (benzocyclobutene, BCB) polymer.

In an optional manner of the first aspect, the lower electrode layer is a substrate layer. Alternatively, the photodetector further includes a substrate layer, and the substrate layer is located between the dielectric layer and the absorption layer.

In an optional manner of the first aspect, the substrate layer includes an upper surface and a lower surface that are perpendicular to the first direction, and includes the upper surface and the lower surface in sequence in the first direction. A groove is provided on the lower surface. The dielectric layer is disposed in the groove. The dielectric layer is disposed on the lower surface of the substrate layer, so that machining difficulty can be reduced, thereby reducing machining costs of the photodetector.

In an optional manner of the first aspect, a distance d between a bottom of the groove and the upper surface ranges from 1 micron (micron, µm) to 20 µm. The distance d is controlled, so that a distance between the dielectric layer and the absorption layer can be reduced, thereby improving the optical field localization effect of the dielectric layer.

In an optional manner of the first aspect, a thickness of the dielectric layer is less than or equal to a difference between D and d. D is a thickness of the substrate layer. The thickness of the dielectric layer is limited, so that a size of the photodetector can be reduced, thereby reducing the costs of the photodetector.

In an optional manner of the first aspect, the dielectric layer and the substrate layer are disposed in parallel. The dielectric layer and the substrate layer that are disposed in parallel can reduce the machining difficulty, thereby reducing the machining costs of the photodetector.

In an optional manner of the first aspect, a thickness of the substrate layer ranges from 1 µm to 30 µm. The thickness of the substrate layer is limited, so that a distance between the dielectric layer and the absorption layer can be reduced, thereby improving the optical field localization effect.

In an optional manner of the first aspect, a thickness of the dielectric layer ranges from 0.1 µm to 1000 µm. The thickness of the dielectric layer is limited, so that a size of the photodetector can be reduced, thereby reducing the costs of the photodetector.

In an optional manner of the first aspect, a thickness of the absorption layer ranges from 200 nanometres (nanometres, nm) to 1000 nm. In this application, quantum efficiency of the photodetector can be improved by introducing the dielectric layer. Therefore, in this application, a response speed of the photodetector can be improved by reducing the thickness of the absorption layer.

In an optional manner of the first aspect, a distance between a center of the projection and a center of the dielectric metasurface is less than or equal to 100 nm. An overlapping area between the projection and the dielectric metasurface can be increased by limiting the distance between the two centers. The area of the overlapping region is related to the quantum efficiency of the photodetector. The quantum efficiency of the photodetector can be improved by increasing the overlapping area.

In an optional manner of the first aspect, the projection covers the dielectric metasurface. When the projection covers the dielectric metasurface, the overlapping area between the projection and the dielectric metasurface can be increased. The quantum efficiency of the photodetector can be improved by increasing the overlapping area.

In an optional manner of the first aspect, materials of the upper electrode layer and the lower electrode layer are indium phosphide InP. A material of the absorption layer is indium gallium arsenide InGaAs.

In an optional manner of the first aspect, the photodetector further includes a field control layer and an avalanche layer. The field control layer is located between the absorption layer and the avalanche layer. The avalanche layer is located between the field control layer and the lower electrode layer.

A second aspect of this application provides an optical receiver module. The optical receiver module includes a digital-to-analog converter and the III-V semiconductor photodetector according to any one of the first aspect or the optional manners of the first aspect. The photodetector is configured to: receive an optical signal, and convert the optical signal into an analog electrical signal. The digital-to-analog converter is configured to convert the analog electrical signal into a digital electrical signal.

A third aspect of this application provides an optical communication device. The optical communication device includes a processor and the optical receiver module according to the second aspect. The optical receiver module is configured to output a digital electrical signal. The processor is configured to perform data processing on the digital electrical signal.

A fourth aspect of this application provides a machining method of a III-V semiconductor photodetector. The machining method of the photodetector includes the following steps: epitaxially growing an absorption layer on a lower electrode layer; epitaxially growing an upper electrode layer on the absorption layer; fabricating a dielectric metasurface on the upper electrode layer; and disposing a dielectric layer on a lower surface of the lower electrode layer. A refractive index of the dielectric layer is less than a refractive index of the absorption layer.

In an optional manner of the fourth aspect, a groove is etched on the lower surface of the lower electrode layer in a direction opposite to a first direction, and the dielectric layer is deposited or bonded in the groove.

### BRIEF DESCRIPTION OF DRAWINGS

FIG. 1 is a diagram of a first structure of a photodetector according to an embodiment of this application;
FIG. 2 is a diagram of a second structure of a photodetector according to an embodiment of this application;
FIG. 3 is a diagram of a third structure of a photodetector according to an embodiment of this application;
FIG. 4 is a diagram of a fourth structure of a photodetector according to an embodiment of this application;
FIG. 5 is a diagram of a fifth structure of a photodetector according to an embodiment of this application;
FIG. 6 is a diagram of a sixth structure of a photodetector according to an embodiment of this application;
FIG. 7 is a diagram of a structure of an optical receiver module according to an embodiment of this application;
FIG. 8 is a diagram of a structure of an optical communication device according to an embodiment of this application; and
FIG. 9 is a schematic flowchart of a machining method of a photodetector according to an embodiment of this application.

### DESCRIPTION OF EMBODIMENTS

This application provides a III-V semiconductor photodetector, an optical receiver module, and an optical communication device, which introduces a dielectric layer with a low refractive index, to improve an optical field localization effect, thereby improving efficiency corresponding to a dielectric metasurface. Therefore, in this application, quantum efficiency of the photodetector can be improved. It should be understood that "upper", "lower", and the like used in this application are merely used for distinguished descriptions, but should not be understood as an indication or implication of relative importance or an indication or implication of a sequence. In addition, for brevity and clarity, reference numbers and/or letters are repeated in a plurality of accompanying drawings of this application. Repetition is not indicative of a strict limiting relationship between various embodiments and/or configurations.

The III-V semiconductor photodetector in this application is a photodetector including a group III element and a group V element. For example, the group III element includes boron B, aluminum Al, gallium Ga, indium In, or another element. The group V element includes nitrogen N, phosphorus P, arsenic As, antimony Sb, or another element. The III-V semiconductor photodetector in this application is used in the field of semiconductor devices. In the field of semiconductor devices, a dielectric metasurface may be disposed on a silicon-germanium semiconductor photodetector to improve quantum efficiency of the photodetector, so as to resolve mutual restriction between a response speed and the quantum efficiency. However, the dielectric metasurface is not well applied in the III-V semiconductor photodetector, to effectively improve the quantum efficiency of the photodetector as expected.

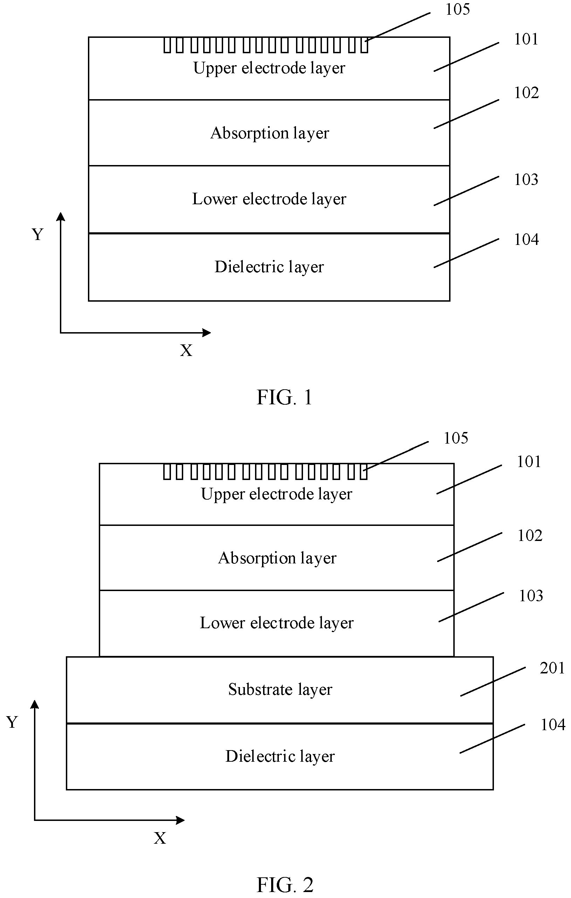

To resolve this problem, this application provides a III-V semiconductor photodetector. For ease of description, the III-V semiconductor photodetector is referred to as a photodetector for short. FIG. 1 is a diagram of a first structure of a photodetector according to an embodiment of this application. As shown in FIG. 1, the photodetector includes an upper electrode layer 101, an absorption layer 102, a lower electrode layer 103, and a dielectric layer 104 in sequence in a negative direction of a Y axis. The negative direction of the Y axis is also referred to as a first direction. Materials of the upper electrode layer 101 and the lower electrode layer 103 each may be indium gallium arsenide InGaAs, indium gallium arsenide phosphide InGaAsP, aluminum gallium indium arsenide AlGaInAs, indium phosphide InP, or the like. The upper electrode layer 101 and the lower electrode layer 103 are used to provide a bias voltage for the absorption layer 102. A material of the absorption layer 102 may be the InGaAs, gallium arsenide GaAs, the InGaAsP, or the like. The absorption layer 102 is used to: receive an optical signal, and convert the optical signal into an electrical signal based on the bias voltage.

A dielectric metasurface 105 is disposed on the upper electrode layer 101. The dielectric metasurface includes a plurality of resonant units with special electromagnetic characteristics. The dielectric metasurface 105 is used to enable the optical signal to resonate in the absorption layer 102. A shape of the dielectric metasurface 105 may be a circle, an ellipse, a polygon, or another random shape. The polygon may be a tetragonal lattice, a hexagonal lattice, a quasi-lattice, or the like. Shapes of the resonant units may include one or a combination of a plurality of the following: a nanopore, a nanopillar, a nanosphere, a nanoring, and a nanorod. A material of the dielectric metasurface 105 may be the same as or different from that of the upper electrode layer 101.

A material of the dielectric layer 104 may be air, silicon dioxide, a benzocyclobutene (benzocyclobutene, BCB) polymer, or the like. There is an overlapping region between a projection of the dielectric layer 104 on the upper electrode layer 101 and the dielectric metasurface 105. That there is an overlapping region between a projection of the dielectric layer 104 on the upper electrode layer 101 and the dielectric metasurface 105 may alternatively be understood as follows: There is an overlapping region between a projection of the dielectric layer 104 on a first plane and a projection of the dielectric metasurface 105 on the first plane. The first plane is on the upper electrode layer 101 and is perpendicular to the Y axis. A refractive index of the dielectric layer 104 is less than a refractive index of the absorption layer 102.

In this embodiment of this application, after being incident to the photodetector, the optical signal is regulated by the dielectric metasurface, so that an optical signal with a specific wavelength generates transverse resonance in the absorption layer 102 of the photodetector. The refractive index of the dielectric layer 104 is less than the refractive index of the absorption layer 102. Therefore, the dielectric layer 104 can better limit the optical signal to the absorption layer 102, to improve an optical field localization effect, thereby improving efficiency corresponding to the dielectric metasurface. Therefore, in this embodiment of this application, quantum efficiency of the photodetector can be improved.

In this embodiment of this application, the quantum efficiency of the photodetector can be improved by introducing the dielectric layer 104. Therefore, in this application, a response speed of the photodetector can be improved by reducing a thickness of the absorption layer 102. For example, the thickness of the absorption layer 102 may range from 200 nm to 1000 nm. The thickness of the absorption layer 102 may be 200 nm or 1000 nm.

In this embodiment of this application, to improve the optical field localization effect of the dielectric layer 104, there is the overlapping region between the projection of the dielectric layer 104 on the upper electrode layer 101 and the dielectric metasurface 105. An area of the overlapping region, which is related to the quantum efficiency of the photodetector, can be increased by controlling a distance between a center of the projection and a center of the dielectric metasurface. For example, the distance may be less than or equal to 100 nm. The distance is an X-axis dimension. For example, a coordinate of the center of the projection on the X axis is X1. A coordinate of the center of the dielectric metasurface on the X axis is X2. The distance is an absolute value of a difference between X1 and X2.

In practice, machining costs of the dielectric metasurface are usually higher than machining costs of the dielectric layer 104. To improve utilization of the dielectric metasurface as much as possible, the projection of the dielectric layer 104 on the upper electrode layer 101 may cover the dielectric metasurface. In addition, when the projection covers the dielectric metasurface, the area of the overlapping region is accordingly increased, thereby improving the quantum efficiency of the photodetector.

In practice, the photodetector may further include a substrate layer. In a first implementation, in FIG. 1, the lower electrode layer 103 is used as a substrate layer 103. In this case, the photodetector includes the upper electrode layer 101, the absorption layer 102, the substrate layer 103, and the dielectric layer 104 in sequence in the first direction. In a second implementation, the photodetector further includes both the substrate layer and the lower electrode layer. FIG. 2 is a diagram of a second structure of a photodetector according to an embodiment of this application. As shown in FIG. 2, based on FIG. 1, the photodetector further includes a substrate layer 201. The substrate layer 201 is located between the lower electrode layer 103 and the dielectric layer 104. In this case, the photodetector includes the upper electrode layer 101, the absorption layer 102, the lower electrode layer 103, the substrate layer 201, and the dielectric layer 104 in sequence in the first direction. A material of the substrate layer 201 may be the InP, the GaAs, GaN (gallium nitride), silicon carbide SiC, or the like. In subsequent examples, the lower electrode layer 103 in FIG. 1 is used as the substrate layer 103 for description.

In FIG. 1, the dielectric layer 104 and the substrate layer 103 are disposed in parallel. Therefore, a thickness of the dielectric layer 104 affects a size of the photodetector. To reduce the size of the photodetector, the thickness of the dielectric layer 104 may range from 0.1 µm to 1000 µm. A thickness of the substrate layer 103 may be 0.1 µm or 10 µm.

In FIG. 1, the substrate layer 103 is located between the dielectric layer 104 and the absorption layer 102. In this case, the thickness of the substrate layer 103 affects a distance between the dielectric layer 104 and the absorption layer 102, and consequently, affects the optical field localization effect of the dielectric layer 104. Therefore, in this embodiment of this application, the optical field localization effect of the dielectric layer 104 can be improved by controlling the thickness of the substrate layer 103. For example, the thickness of the substrate layer ranges from 1 µm to 30 µm. The thickness of the substrate layer may be 1 µm or 30 µm.

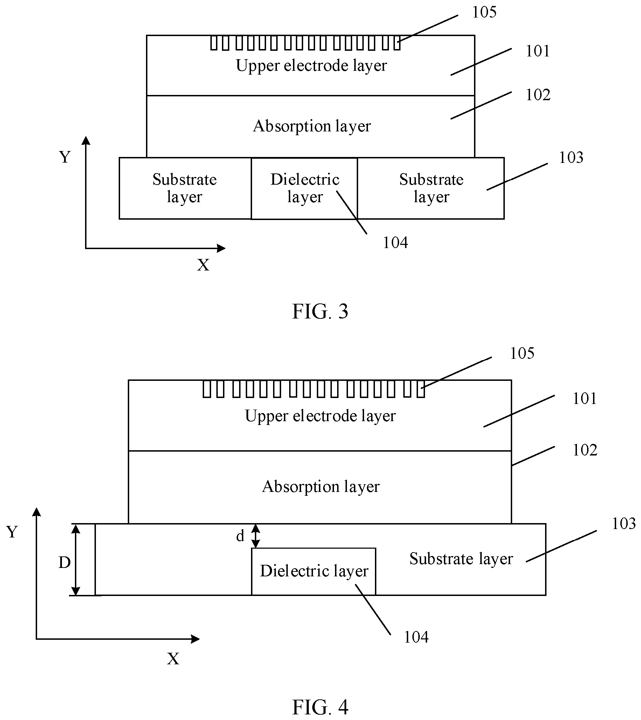

To further reduce the distance between the dielectric layer 104 and the absorption layer 102, the dielectric layer 104 may be located in a through hole of the substrate layer 103. FIG. 3 is a diagram of a third structure of a photodetector according to an embodiment of this application. As shown in FIG. 3, the photodetector includes an upper electrode layer 101, an absorption layer 102, and a substrate layer 103 in sequence in a first direction. A dielectric metasurface 105 is disposed on the upper electrode layer 101. A through hole is provided on the substrate layer 103. A width of the through hole is less than a width of the absorption layer 102. The width is an X-axis direction dimension. A dielectric layer 104 is located in the through hole. A thickness of the dielectric layer 104 is equal to a thickness of the substrate layer 103. The thickness is a Y-axis direction dimension.

When a lower electrode layer 103 is used as the substrate layer 103, the substrate layer 103 is used to provide for the absorption layer 102 a bias voltage, whose efficiency can be improved by increasing a contact area between the substrate layer 103 and the absorption layer 102. In this case, the dielectric layer 104 may be located in a groove on a lower surface of the substrate layer 103. FIG. 4 is a diagram of a fourth structure of a photodetector according to an embodiment of this application. As shown in FIG. 4, the photodetector includes an upper electrode layer 101, an absorption layer 102, and a substrate layer 103 in sequence in a first direction. A dielectric metasurface 105 is disposed on the upper electrode layer 101. The substrate layer 103 includes an upper surface and a lower surface that are perpendicular to the first direction, and includes the upper surface and the lower surface in sequence in the first direction. A groove is provided on the lower surface. A dielectric layer 104 is disposed in the groove.

In FIG. 4, a distance between a bottom of the groove and the upper surface of the substrate layer 103 is d. When a thickness of d is increased, an optical field localization effect of the dielectric layer 104 is reduced. Therefore, in this embodiment of this application, the optical field localization effect of the dielectric layer 104 can be improved by controlling the thickness of d. For example, a value of d ranges from 1 µm to 20 µm. The value of d may be 1 µm or 20 µm. In FIG. 3 and FIG. 4, the thickness of the substrate layer 103 is D. To reduce a size of the photodetector, the thickness of the dielectric layer 104 may be less than or equal to a difference between D and d.

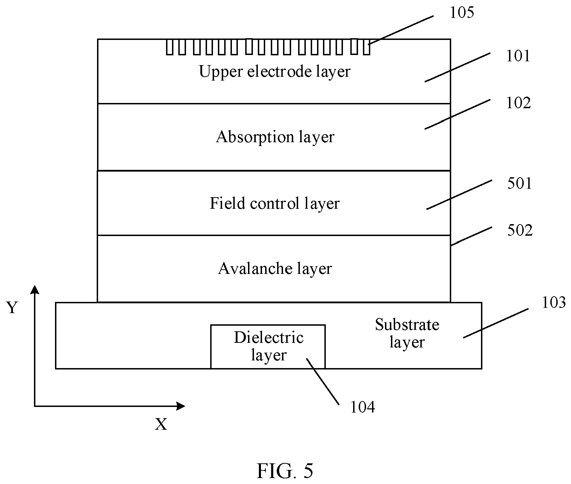

In practice, the photodetector may further include a field control layer and an avalanche layer. FIG. 5 is a diagram of a fifth structure of a photodetector according to an embodiment of this application. As shown in FIG. 5, based on FIG. 4, the photodetector may further include a field control layer 501 and an avalanche layer 502. In this case, the photodetector includes the upper electrode layer 101, the absorption layer 102, the field control layer 501, the avalanche layer 502, and the substrate layer 103 in sequence in the first direction. The dielectric metasurface 105 is disposed on the upper electrode layer 101. The dielectric layer 104 is disposed in the groove of the substrate layer 103. The field control layer 501 is also referred to as a doping layer. The avalanche layer 502 is also referred to as a multiplication layer. A material of the field control layer 501 may be InGaAsP, AlGaInAs, indium aluminum arsenide InAlAs, InP, or the like. The field control layer 501 is used to regulate electric field distribution of the absorption layer 102 and the avalanche layer 502. A material of the avalanche layer 502 may be the InAlAs, the InP, aluminum gallium arsenide antimonide AlGaAsSb, or the like. The avalanche layer 502 is used to multiply a quantity of photogenerated charge carriers, to amplify a photocurrent.

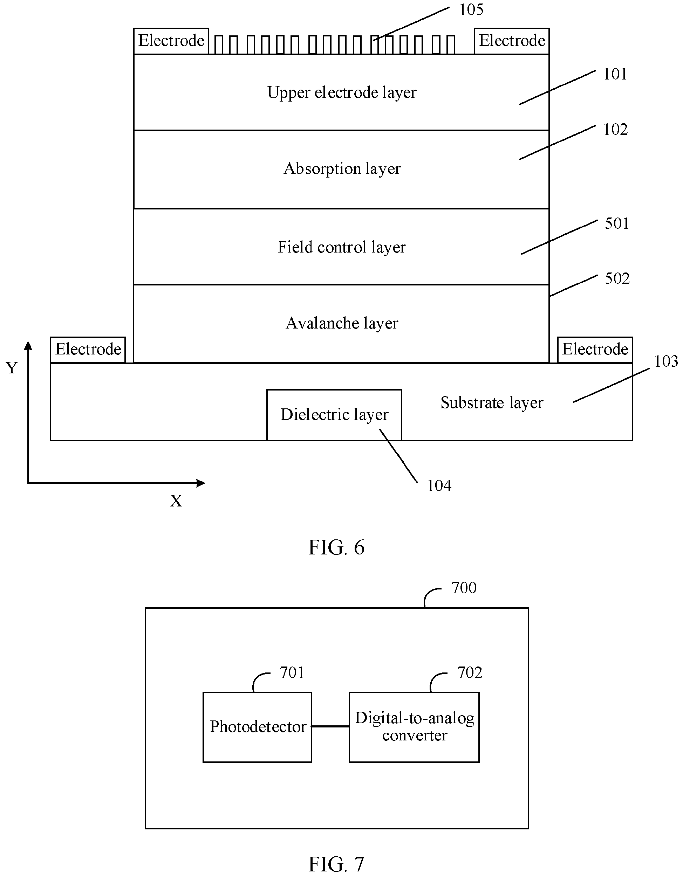

In the foregoing examples of FIG. 1 to FIG. 5, the dielectric metasurface 105 is located beneath an upper surface of the upper electrode layer 101. In practice, the dielectric metasurface 105 may alternatively be located on an upper surface. FIG. 6 is a diagram of a sixth structure of a photodetector according to an embodiment of this application. As shown in FIG. 6, a dielectric metasurface 105 is disposed on an upper surface of an upper electrode layer 101. Electrodes are disposed on the upper electrode layer 101 and a substrate layer 103. The electrodes are used to connect to a power supply.

In the foregoing examples of FIG. 1 to FIG. 6, a shape of the dielectric layer 104 in the photodetector is a cuboid. In practice, the shape of the dielectric layer 104 may be a cubic shape, a bowl shape, a cone shape, a columnar shape, a spherical shape, or the like.

The photodetector provided in embodiments of this application may be used in different bands. For the different bands, photodetectors of different structures may be designed. The following provides an example of a structure of a photodetector used in an O band (1260 nm to 1360 nm). The material of the upper electrode layer 101 is the InP. A thickness of the upper electrode layer 101 is 1 µm. The material of the absorption layer 102 is the InGaAs. The thickness of the absorption layer 102 is 0.6 µm. Thicknesses of the field control layer 501 and the avalanche layer 502 are both 0.4 µm. Materials of the field control layer 501 and the avalanche layer 502 are the InAlAs. A material of the substrate layer 103 is the InP. The thickness of the substrate layer 103 is 1 µm. The material of the dielectric layer 104 is the air. The thickness of the dielectric layer 104 ranges from 1 µm to 10 µm. The shape of the dielectric metasurface 105 is the circle. A radius of the circle ranges from 0.3 µm to 0.5 µm. A periodicity of the dielectric metasurface 105 ranges from 0.9 µm to 1.2 µm. The periodicity of the dielectric metasurface 105 is a distance between centers of two resonant units. The dielectric metasurface 105 is located beneath the upper surface of the upper electrode layer 101. A thickness of the dielectric metasurface 105 ranges from 0.4 µm to 0.9 µm. Resonance enhancement bands of the dielectric metasurface 105 and the dielectric layer 104 are within an absorption frequency spectrum range of the absorption layer 102.

The photodetector may further include a passivation layer. The passivation layer is located at an outer layer of the photodetector, and is made of an insulating dielectric material. The passivation layer is transparent to a detection band of the photodetector and increases transmittance. The passivation layer may be further used to: protect the photodetector, reduce a dark current, and prevent a short circuit between a positive electrode and a negative electrode of the photodetector. A refractive index of the passivation layer is less than the refractive index of the absorption layer 102. The material of the passivation layer may be the silicon dioxide, silicon nitride, silicon oxynitride, or the like.

In practice, a larger difference between the refractive index of the dielectric layer 104 and the refractive index of the absorption layer 103 indicates a more obvious improvement of the optical field localization effect. To improve the optical field localization effect, the refractive index of the dielectric layer 104 may range from 1 to 1.5. For example, the refractive index of the dielectric layer 104 is 1 or 1.5.

It should be understood that FIG. 1 to FIG. 6 are merely several examples of the photodetector provided in this application. In practice, a person skilled in the art may modify the diagram of the structure of the photodetector based on needs. For example, in FIG. 4, the groove is provided on the lower surface of the substrate layer 103, and the dielectric layer 104 is located in the groove. In practice, the groove may be located in the upper surface of the substrate layer 103.

An embodiment of this application further provides an optical receiver module. FIG. 7 is a diagram of a structure of an optical receiver module according to an embodiment of this application. As shown in FIG. 7, the optical receiver module 700 includes a digital-to-analog converter 702 and a photodetector 701. For descriptions of the photodetector 701, refer to the descriptions in any one of FIG. 1 to FIG. 6. The photodetector 701 is configured to: receive an optical signal, and convert the optical signal into an analog electrical signal. The digital-to-analog converter 702 is configured to convert the analog electrical signal into a digital electrical signal.

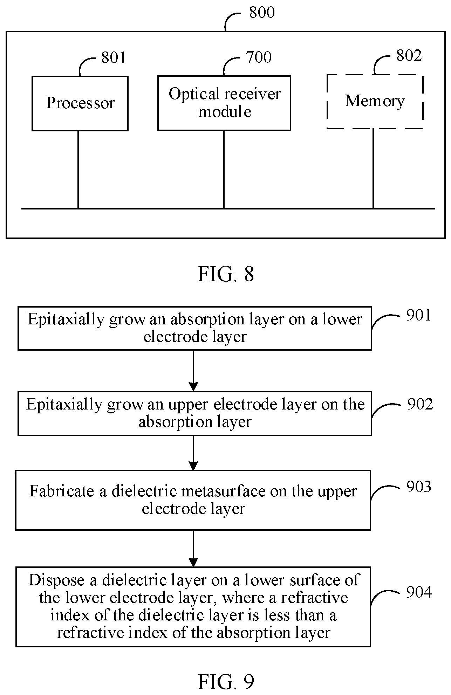

An embodiment of this application further provides an optical communication device. FIG. 8 is a diagram of a structure of an optical communication device according to an embodiment of this application. As shown in FIG. 8, the optical communication device 800 includes a processor 801 and an optical receiver module 700. For descriptions of the optical receiver module 700, refer to the descriptions in FIG. 7. The optical receiver module 700 is configured to output a digital electrical signal. The processor 801 may be a central processing unit (central processing unit, CPU), a network processor (network processor, NP), or a combination of a CPU and an NP. The processor 801 may alternatively be a graphics processing unit (graphics processing unit, GPU). The processor 801 may further include a hardware chip or another general-purpose processor. The hardware chip may be an application-specific integrated circuit (application-specific integrated circuit, ASIC), a programmable logic device (programmable logic device, PLD), or a combination thereof. The processor 801 is configured to perform data processing on, for example, store, perform an operation on, or reply to, the digital electrical signal.

In another embodiment, the optical communication device may further include a memory 802. The memory 802 may be a volatile memory or a non-volatile memory, or may include a volatile memory and a non-volatile memory. The non-volatile memory may be a read-only memory (read-only memory, ROM), a programmable read-only memory (programmable ROM, PROM), an erasable programmable read-only memory (erasable PROM, EPROM), a flash memory, or the like. The volatile memory may be a random access memory (random access memory, RAM). The memory 802 is configured to store the digital electrical signal.

The foregoing describes the photodetector, the optical receiver module, and the optical communication device provided in embodiments of this application. The following describes a machining method of the III-V semiconductor photodetector provided in embodiments of this application. FIG. 9 is a schematic flowchart of a machining method of a photodetector according to an embodiment of this application. As shown in FIG. 9, the machining method of the photodetector includes the following steps.

In step 901, an absorption layer is epitaxially grown on a lower electrode layer. A material of the lower electrode layer may be InGaAs, InGaAsP, AlGaInAs, InP, or the like. A material of the absorption layer may be the InGaAs, GaAs, the InGaAsP, or the like.

In step 902, an upper electrode layer is epitaxially grown on the absorption layer. A material of the upper electrode layer may be the InGaAs, the InGaAsP, the AlGaInAs, the InP, or the like.

In step 903, a dielectric metasurface is fabricated on the upper electrode layer. A shape of the dielectric metasurface may be a circle, an ellipse, a polygon, or another random shape. The polygon may be a tetragonal lattice, a hexagonal lattice, a quasi-lattice, or the like. Shapes of sub-wavelength resonant units may include one or a combination of a plurality of the following: a nanopore, a nanopillar, a nanosphere, a nanoring, and a nanorod. A procedure of fabricating the dielectric metasurface may include the following steps: obtaining a photoresist layer through spin coating on the upper electrode layer; forming a shape of the dielectric metasurface on the photoresist layer through exposure and development; transferring the shape of the dielectric metasurface to the upper electrode layer through etching; and removing the photoresist layer.

In step 904, a dielectric layer is disposed on a lower surface of the lower electrode layer. A refractive index of the dielectric layer is less than a refractive index of the absorption layer. A material of the dielectric layer may be air, silicon dioxide, a BCB polymer, or the like. In a manner, the dielectric layer may be deposited on the lower surface of the lower electrode layer. In another manner, a groove is etched on the lower surface of the lower electrode layer in a direction opposite to a first direction, and the dielectric layer is deposited or bonded in the groove.

An optical resonance enhancement band of the dielectric metasurface may be changed by controlling a periodicity, a size, or a thickness of the dielectric metasurface. An optical signal may be locally limited to the absorption layer by controlling a size, a thickness, or a location of the dielectric layer, to improve quantum efficiency of the photodetector. The size, the thickness, or the like of each of the dielectric metasurface and the dielectric layer may be correspondingly designed based on a selected material and an optical absorption frequency range.

It should be understood that, for descriptions of the machining method of the photodetector, refer to the descriptions of the photodetector in FIG. 1 to FIG. 6. For example, in FIG. 5 and FIG. 6, the photodetector further includes the field control layer and the avalanche layer. In this case, the machining method of the photodetector may further include the following step: epitaxially growing the field control layer and the avalanche layer on the lower electrode layer. For another example, in FIG. 2, the photodetector includes both the substrate layer and the lower electrode layer. In this case, the lower electrode layer may be obtained through machining on the substrate layer.

The foregoing descriptions are merely specific implementations of this application, but are not intended to limit the protection scope of this application. Any variation or replacement readily figured out by a person skilled in the art within the technical scope disclosed in this application shall fall within the protection scope of this application.

## Claims

1. A III-V semiconductor photodetector, comprising an upper electrode layer, an absorption layer, and a lower electrode layer in sequence in a first direction, wherein
the upper electrode layer and the lower electrode layer are used to provide a bias voltage for the absorption layer;
the absorption layer is used to: receive an optical signal, and convert the optical signal into an electrical signal based on the bias voltage;
a dielectric metasurface is disposed on the upper electrode layer, and the dielectric metasurface is used to enable the optical signal to resonate in the absorption layer; and
the photodetector further comprises a dielectric layer, the absorption layer is located between the dielectric layer and the upper electrode layer, there is an overlapping region between a projection of the dielectric layer on the upper electrode layer and the dielectric metasurface, and a refractive index of the dielectric layer is less than a refractive index of the absorption layer.

2. The photodetector according to claim 1, wherein the refractive index of the dielectric layer ranges from 1 to 1.5.

3. The photodetector according to claim 1 or 2, wherein a material of the dielectric layer is air, silicon dioxide, or a benzocyclobutene BCB polymer.

4. The photodetector according to any one of claims 1 to 3, wherein the lower electrode layer is a substrate layer, or the photodetector further comprises a substrate layer, and the substrate layer is located between the dielectric layer and the absorption layer.

5. The photodetector according to claim 4, wherein the substrate layer comprises an upper surface and a lower surface that are perpendicular to the first direction, and comprises the upper surface and the lower surface in sequence in the first direction, wherein
a groove is provided on the lower surface, and the dielectric layer is disposed in the groove.

6. The photodetector according to claim 5, wherein a distance d between a bottom of the groove and the upper surface ranges from 1 µm to 20 µm.

7. The photodetector according to claim 6, wherein a thickness of the dielectric layer is less than or equal to a difference between D and d, and D is a thickness of the substrate layer.

8. The photodetector according to claim 4, wherein the dielectric layer and the substrate layer are disposed in parallel.

9. The photodetector according to claim 8, wherein a thickness of the substrate layer ranges from 1 µm to 30 µm.

10. The photodetector according to claim 8 or 9, wherein a thickness of the dielectric layer ranges from 0.1 µm to 1000 µm.

11. The photodetector according to any one of claims 1 to 10, wherein a thickness of the absorption layer ranges from 200 nm to 1000 nm.

12. The photodetector according to any one of claims 1 to 11, wherein a distance between a center of the projection and a center of the dielectric metasurface is less than or equal to 100 nm.

13. The photodetector according to any one of claims 1 to 12, wherein the projection covers the dielectric metasurface.

14. The photodetector according to any one of claims 1 to 13, wherein materials of the upper electrode layer and the lower electrode layer are indium phosphide InP, and a material of the absorption layer is indium gallium arsenide InGaAs.

15. The photodetector according to any one of claims 1 to 14, wherein the photodetector further comprises a field control layer and an avalanche layer, the field control layer is located between the absorption layer and the avalanche layer, and the avalanche layer is located between the field control layer and the lower electrode layer.

16. An optical receiver module, comprising a digital-to-analog converter and the III-V semiconductor photodetector according to any one of claims 1 to 15, wherein
the III-V semiconductor photodetector is configured to: receive an optical signal, and convert the optical signal into an analog electrical signal; and
the digital-to-analog converter is configured to convert the analog electrical signal into a digital electrical signal.

17. An optical communication device, comprising a processor and the optical receiver module according to claim 16, wherein
the optical receiver module is configured to output a digital electrical signal; and
the processor is configured to perform data processing on the digital electrical signal.

18. A machining method of a III-V semiconductor photodetector, comprising
epitaxially growing an absorption layer on a lower electrode layer;
epitaxially growing an upper electrode layer on the absorption layer;
fabricating a dielectric metasurface on the upper electrode layer; and
disposing a dielectric layer on a lower surface of the lower electrode layer, wherein a refractive index of the dielectric layer is less than a refractive index of the absorption layer.

19. The machining method according to claim 18, wherein
the disposing a dielectric layer on a lower surface of the lower electrode layer comprises: etching a groove on the lower surface of the lower electrode layer in a direction opposite to a first direction, and depositing or bonding the dielectric layer in the groove.
